# EUROPEAN PATENT APPLICATION

(11) **EP 2 693 289 A1**
(43) Date of publication of application: **05.02.2014**
(21) Application number: 12764941.6
(22) Date of filing: 16.03.2012
(51) Int. Cl.: G05F 1/67, H01L 31/04

(54) **CURRENT COLLECTION BOX**

(30) Priority: 30.03.2011 JP 2011076299
(71) Applicant: Sanyo Electric Co., Ltd., Osaka 570-8677 (JP)
(72) Inventor: MIYAUCHI Taku, Moriguchi-shi, Osaka 570-8677 (JP); ANDO Takashi, Moriguchi-shi, Osaka 570-8677 (JP)
(74) Representative: Glawe, Delfs, Moll
(86) International application number: PCT/JP2012/056804
(87) International publication number: WO 2012/132949

(57) **Abstract**

A current collection box (4) is provided with lines (La to Ld) which are connected to each of a plurality of solar cells (1a to 1d), and boosting circuits (41a to 41 d) which are interposed upon each of at least two or more lines of the plurality of lines (La to Ld) so as to boost the output voltage of the solar cells (1a to 1d), and outputs the output of each of the lines (La to Ld) together. In the current collection box (4), each of the boosting circuits (41a to 41d) starts MPPT operation, which operates so that the output power of the solar cells (1a to 1d) is maximized, with different periods each.

## Description

### TECHNICAL FIELD

The present invention relates to a grid-connected system for converting a direct current power generated by solar cells into an alternating current power and superimposing same onto a commercial power grid.

### BACKGROUND ART

The prior art has proposed a grid-connected system including a power line for boosting and supplying a power generated by solar cells in a case where a plurality of solar cell strings (also called simply "solar cells") in which a plurality of solar cells are connected in series are installed, and a power line for directly supplying, without boosting, the output generated by the solar cells, and also including a power conversion device for combining the output generated by the solar cells, obtained via these two lines, together into a single power line in a current collection box, outputting and thereafter converting the output to an alternating current power, and directly superimposing same onto a commercial power grid.

### (Patent reference 1)

### Patent reference 1: Japanese Laid-open Patent Application Publication 2002-238246

In the grid-connected system of such description, boosters inside the current collection box carry out a maximum power point tracking (MPPT) operation for controlling the boosting ratios in the boosters so that the power generated by the solar cells tracks a maximum. Likewise, in the power conversion device as well, an MPPT operation for operating so that the outputted direct current power tracks a maximum is also carried out.

The MPPT operations carried out in the current collection box generally comprise increasing or reducing the boosting ratio of a booster and monitoring the power outputted by the solar cells (the value of the product of the current and the voltage) and, in a case where the generated power by the solar cells is increased by the modification to the boosting ratio, continuing to change the boosting ratio in the same direction (increasing when the boosting ratio has been increased or decreasing when the boosting ratio has been decreased) but, in a case where the power is decreased, changing the boosting ratio in the inverse direction (decreasing when the boosting ratio has been increased or increasing when the boosting ratio has been decreased).
This control converges the boosting ratios of the boosters to a position at which the power outputted by the solar cells tracks a maximum value.

The MPPT operation of the power conversion device is carried out by making use of the fact that the direct current power outputted by a current collection box 4 is substantially equal to a power outputted by an inverter circuit for converting the direct current power to an alternating current power (not taking conversion efficiency into account).
This MPPT operation comprises increasing or reducing a target value of the output current of the inverter circuit 23 when the voltage of the commercial power grid is stable, and seeking a target current value at which the output power of the inverter circuit tracks a maximum value (i.e., at which the input power of the power conversion device tracks a maximum value). At this time, the boosting ratio is determined so that a current of the target value is outputted from the inverter circuit.

When the MPPT operation of the boosters is carried out in the current collection box 4, the power outputted by the solar cells fluctuates, and this fluctuation manifests as a fluctuation in the power outputted (current outputted) by the power conversion device. For this reason, when the MPPT operation of the boosters of the current collection box 4 and the MPPT operation of the power conversion device are carried out at the same time, in some cases the dual MPPT operations interfere with each other and the boosting ratios do not quite reach convergence.

The grid-connected system disclosed in patent reference 1, in order to remove the defect caused by such interference, has the MPPT operation of the booster and the MPPT operation of the power conversion device carried out in alternation, thus eliminating the interference between each of the MPPT operations.

### DISCLOSURE OF THE INVENTION

### [Problems the Invention Is Intended To Solve]

However, in the grid-connected system of such description, circuits in which the MPPT operation is to be carried out are selected by a shared control circuit and MPPT operations are carried out in sequence, and therefore a problem has emerged in that in a case where the number of solar cells (solar cell strings) is increased or decreased, then information about the increasing or decreasing boosters needs to be set for the shared control circuit, and cumbersome tasks such as modifying the circuits and updating the software become necessary.

The present invention has been contrived in view of the problems described above, it being an object thereof to provide a current collector box for a grid-connected system by which MPPT operations carried out by boosters inside the current collector box can be prevented from interfering with an MPPT operation carried out by a power conversion device.

### [Means for Solving the Abovementioned Problems]

In order to achieve the foregoing object, the present invention is a current collection box provided with a number of terminals enabling the connecting of at least two solar cell strings including a plurality of solar cells are connected in series, the generated power from the solar cell strings inputted via the terminals being controlled so as to track a maximum value and thereafter being outputted, wherein the current collection box is characterized by being provided with a booster for boosting individual voltages of the generated power of each of the solar cell strings inputted via the terminals, and an output circuit for collecting all of the outputs of the boosters together into a single output and then outputting the single output, each of the boosters controlling a boosting ratio to yield a maximum value of generated power corresponding to a voltage applied over a certain duration in respective every predetermined periods, and the periods, and the period during which each of the boosters is actuated being set to a different value.

According to the present invention, an MPPT operation of each of the boosters is begun at respectively different periods, and therefore it is possible to prevent a plurality of this MPPT operation from overlapping with an MPPT operation of a power conversion device at the same time. This makes it easy, even with interference of the MPPT operation, to cast off the state of interference. It is also not necessary to carry out a particular setting for each of the boosters, and the number of solar cells can be easily increased or decreased.

Another aspect is the invention described above, characterized in that when a certain duration of a period is a first duration in which the MPPT operation is carried out and a remaining duration is a second duration in which the MPPT operation is not carried out and the boosting ratio is fixed to a certain value, a duration obtained by taking the sum of the length of the first duration of each of the boosters is shorter than any of the second durations.

Another aspect is the invention described above, characterized in that the boosters are capable of modifying the period.

Another aspect is the invention described above, characterized in that the length of the first duration is modifiable and the length of the second duration is fixed to a predetermined length, and the boosters, when the boosting ratio in the first duration is controlled, stop control of the boosting ratio in the first interval and fix the boosting ratio when the amount of variation in the generated power of the solar cells falls below a predetermined amount, and thereafter in the second duration the operation of the boosters is carried out at the boosting ratio.

Another aspect is the invention described above, characterized in that the boosters have a current detection circuit for detecting a current inputted to or outputted by the boosters, and in a case where the current detected by the current detection circuits is greater than a predetermined value during start-up, the boosters begin the boosting MPPT operation.

### [Effect of the Invention]

According to the present invention, it is possible to provide a grid-connected system making it possible to readily increase or decrease the number of power lines through the boosters for boosting the output voltage of the solar cells and supplying power, while also preventing the MPPT operation carried out by the boosters from interfering with the MPPT operation carried out by the power conversion device.

### BRIEF DESCRIPTION OF THE DRAWINGS

FIG. 1 is a configuration diagram illustrating a solar power generation system 100 as in a first embodiment;
FIG. 2 is a circuitry diagram of a booster of a current collection box belonging to the grid-connected system of the first embodiment;
FIG. 3 is a circuitry diagram of a power conversion device belonging to the grid-connected system of the first embodiment;
FIG. 4 is a flow chart illustrating an operation during start-up of the booster of the current collection box;
FIG. 5 is a flow chart illustrating an operation of the booster of the current collection box for when an MPPT operation of the booster and a constant boosting ratio operation are carried out;
FIG. 6 is a flow chart illustrating an operation of the power conversion device for when an MPPT operation of the power conversion device and a constant target current operation are carried out;
FIG. 7 is a time chart representing when the current collection box and the power conversion device in the first embodiment are operating;
FIG. 8 illustrates an external view of the current collection box 4 belonging to the grid-connected system as in the first embodiment;
FIG. 9 is a time chart representing when a current collection box and a power conversion device in a second embodiment are operating;
FIG. 10 is a configuration diagram illustrating a solar power generation system 100 in which a configuration to which a booster 21 is not provided is employed for a power conversion device 2;
FIG. 11 is a configuration diagram illustrating a solar power generation system 100 in which a solar cell 1a is directly connected to an output side of another booster 41;
FIG. 12 is a time chart representing when, in a case where a fourth duration is zero, the MPPT operation of the booster and the MPPT operation of the power conversion device are executed; and
FIG. 13 is a circuitry diagram of an isolated booster.

### BEST MODE FOR CARRYING OUT THE INVENTION

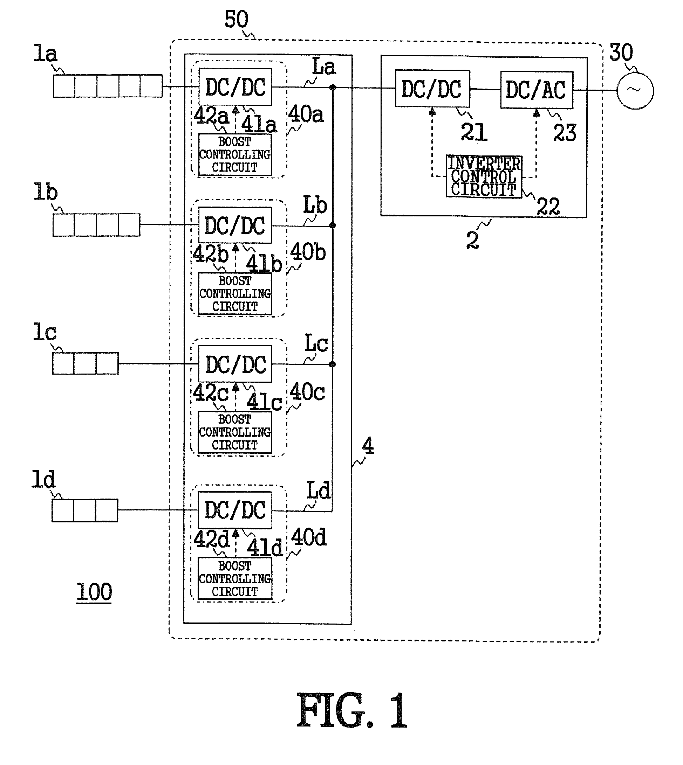

The first embodiment shall now be described below, with reference to the accompanying drawings. FIG. 1 is a configuration diagram illustrating the solar power generation system 100 as in the first embodiment. As illustrated in FIG. 1, the solar power generation system 100 is provided with solar cells 1a to 1d and a grid-connected system 50. The grid-connected system 50 combines power supplied by the solar cells 1a to 1d together and supplies same to a commercial power grid 30.

Each of the solar cells 1a to 1d is configured by connecting cells of solar cells in series. The number of cells of each of the solar cells 1a to 1d changes depending on the surface area on which the solar cells 1a to 1d are installed and the like, and therefore the number varies depending on the solar cells 1a to 1d.

The grid-connected system 50 is provided with a current collection box 4 and a power conversion device 2.

The current collection box 4 includes lines La to Ld respectively connected to the plurality of solar cells 1a to 1d, and boosting units 40a to 40d respectively interposed on the lines La to Ld. The current collection box 4 combines together and outputs the output of each of the lines La to Ld. Each of the boosting units 40a to 40d includes a booster 41a to 41d for boosting an output voltage of the solar cell 1a to 1d, respectively. Each of the boosters 41 a to 41 d also includes a boost controlling circuit 42a to 42d for controlling a boosting operation of the booster 41a to 41d. Each of the boosters 41a to 41d is interposed on the line La to Ld. Each of the boost controlling circuits 42a to 42d is connected to the boost controlling circuit 41 a to 41 d. An output side of the boosters 41 a to 41d has a single connection within the current collection box 4. The current collection box 4 combines together into one the power that is boosted and outputted by the boosters 41 a to 41 d, and outputs a direct current power thus combined to the power conversion device 2.

In the first embodiment, the same numerical reference symbol is given to elements of analogous constitution (e.g., the solar cells are designated "1"), and the same alphabetic reference symbol is given to elements in a connective relationship with one another (a solar cell 1 and a booster 41 in a connective relationship with each other are designated "solar cell 1a" and "booster 41 a," respectively).

Since it would be redundant to provide the same description in instances where the same operation is carried out in similar configurations, the suffixed reference symbols a, b, c, d may be omitted in the following description when the description relates to an operation shared among similar configurations.

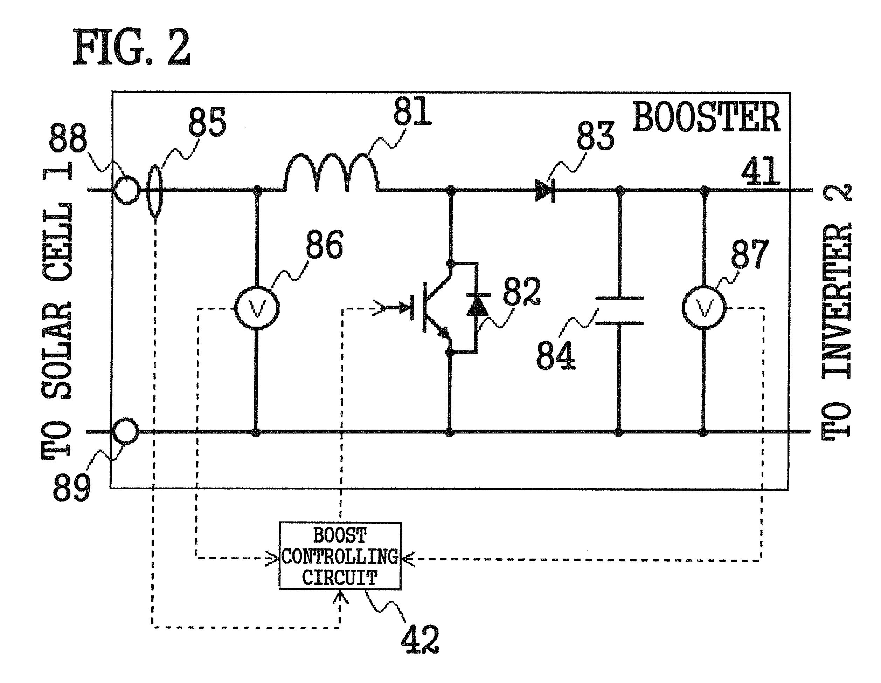

FIG. 2 illustrates a circuitry diagram of a booster of a current collection box belonging to a grid-connected system of a first embodiment. For a booster 41, a "non-isolated booster" is used, which is configured to include: a pair of terminals 88, 89; a reactor 81, a switch element 82 such as an isolated gate bipolar transistor (IGBT), a diode 83, and a capacitor 84. The solar cell 1 is connected to the pair of terminals 88, 89, and the reactor 81 and the diode 83 are connected in series to one terminal (a positive-side terminal) 88 of the terminals 88, 89. The switch element 82 opens and closes between a connecting point between the reactor 81 and the diode 83, and the other terminal of the pair of terminals. The capacitor 84 is connected between the diode 83 and the other terminal.

The booster 41 includes a current sensor 85 for detecting an input current, a voltage sensor 86 for detecting an input voltage, and a voltage sensor 87 for detecting an output voltage. The booster 41 periodically opens and closes the switch element 82 on the basis of information obtained from these sensors, to obtain a predetermined boosting ratio.

The power conversion device 2 is provided with a booster 21 for boosting a direct current power outputted by the current collection box 4, an inverter circuit 23 for converting the direct current power outputted by the booster 21 to an alternating current power, and an inverter control circuit 22 for controlling the operations of the booster 21 and the inverter circuit 23. The power conversion device 2 converts the direct current power outputted by the current collection box 4 to an alternating current power and superimposes same onto the commercial power grid 30.

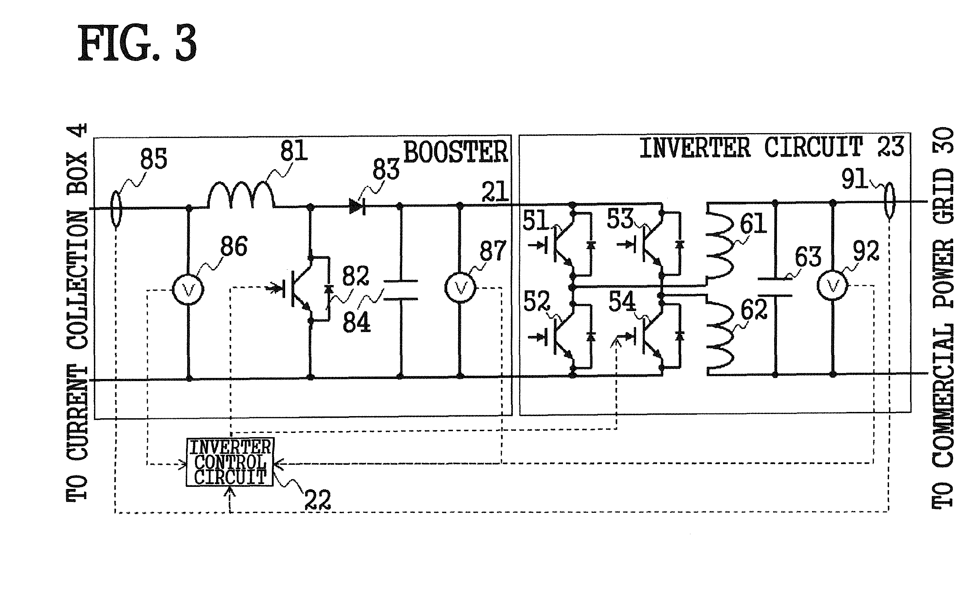

FIG. 3 illustrates a circuitry diagram of a power conversion device belonging to the grid-connected system of the first embodiment. A circuitry configuration similar to that of the booster 41 can be used for the configuration of the booster 21, and therefore a description thereof is omitted. Though the booster 21 uses a similar circuitry configuration, a separate control is carried out by the inverter control circuit 22.

The inverter circuit 23 is configured by connecting in parallel a first arm in which switch elements 51, 52 are connected in series, and a second arm in which switch elements 53, 54 are connected in series. For the switch elements 51 to 54, a switch element such as an IGBT may be used. The inverter circuit 23 periodically opens and closes each of the switch elements 51 to 54 in conformity with a pulse width modulation (PWM) control of the inverter control circuit 22. By opening and closing the switch elements 51 to 54, the inverter circuit 23 converts the direct current power outputted from the booster 21 into a three-phase alternating current power. A filter circuit (low-pass filter) composed of reactors 61, 62 and a capacitor 63 is provided to a subsequent stage of the inverter circuit 23, and attenuates higher frequencies caused by the operation to open and close the switch elements 51 to 54.

The inverter circuit 23 also has a current sensor 91 for detecting the output current of the inverter circuit 23, and a voltage sensor 92 for detecting the output voltage of the inverter circuit 23. The inverter control circuit 22 controls the booster 21 and the inverter circuit 23 by using the current values and voltage values detected by the voltage sensors 86, 87 and current sensor 85 belonging to the booster 21, and by the voltage sensor 92 and the current sensor 91 belonging to the inverter circuit 23.

Next, the operation of the booster 41 of the current collection box 4 and the power conversion device 2 belonging to the grid-connected system 50 of the first embodiment shall now be described, as shall the grid-connected system 50.

### (Operation of the booster of the current collection box)

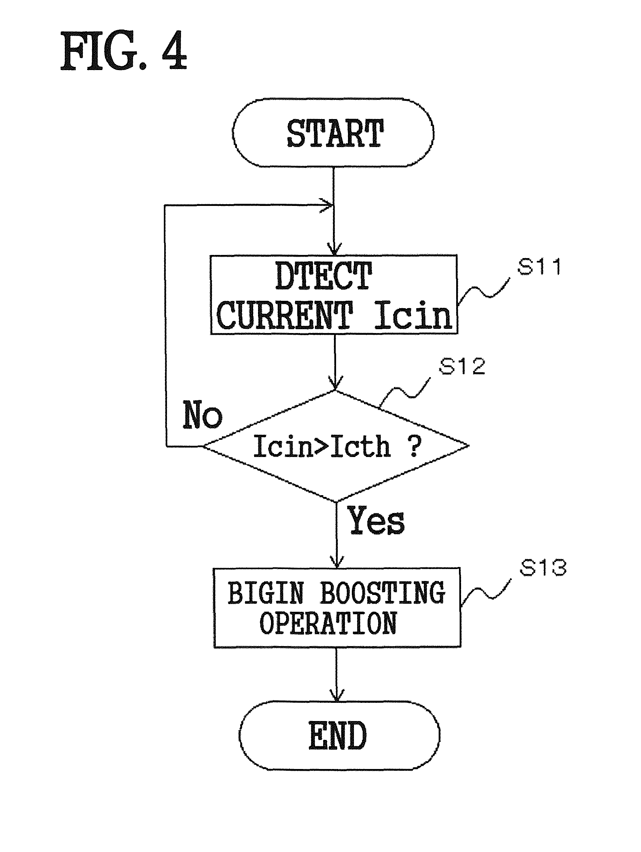

The booster 41 begins boosting up after confirmation of the start-up (connection) of the power conversion device 2 upon start-up. Because of the use of a non-isolated booster for the booster 41 of the current collection box 4, the power conversion device 2 is able to start up because power is supplied via the reactor 81 and the diode 83, even without the booster 41 carrying out a boosting operation. When the power conversion device 2 starts up and begins connection, the start-up (connection) of the power conversion device 2 can be confirmed by an increase in the current detected by the current sensor 85. The operation for when the booster 41 starts up shall now be described with reference to the accompanying drawings. FIG. 4 illustrates a flow chart of the operation during start-up of the booster 41 of the current collection box 4.

A start-up process of the booster 41 comprises detecting an input current Icin to the booster 41, by using the current sensor 85 (step S11), and determining whether or not the input current Icin is greater than a predetermined value Icth (step S 13).

In a case where the input current Icin is not greater than the predetermined value Icth, the booster 41 determines that the power conversion device has not started up, and the flow transitions to step S11. In a case where the input current Icin has increased and is greater than the predetermined value Icth, the power conversion device 2 is determined to have started up, operation of the booster 41 is begun at a previously established boosting ratio r, and the start-up process is concluded.

So doing makes it possible to reduce the number of times the switch element 82 of the booster 41 is opened or closed because at the time of start-up, when the input current Icin is small, the boosting operation is not carried out.

When the operation during start-up is concluded, the boosters 41 begin, at regular intervals of a first period, an MPPT operation for operating so that the output power of the solar cells 1 connected to each other reaches a maximum. More specifically, one period of the first period is divided into a first duration for enabling the MPPT operation of the boosters, and a second duration in which the MPPT operation of the boosters is not carried out. The boosters 41 carry out the MPPT operation during the first duration, but during the second duration carry out a constant boosting ratio operation in which the boosting ratio r is rendered constant (fixed). In this manner, the boosters 41 repeat the MPPT operation of the booster and the constant boosting ratio operation in regular intervals of the first period.

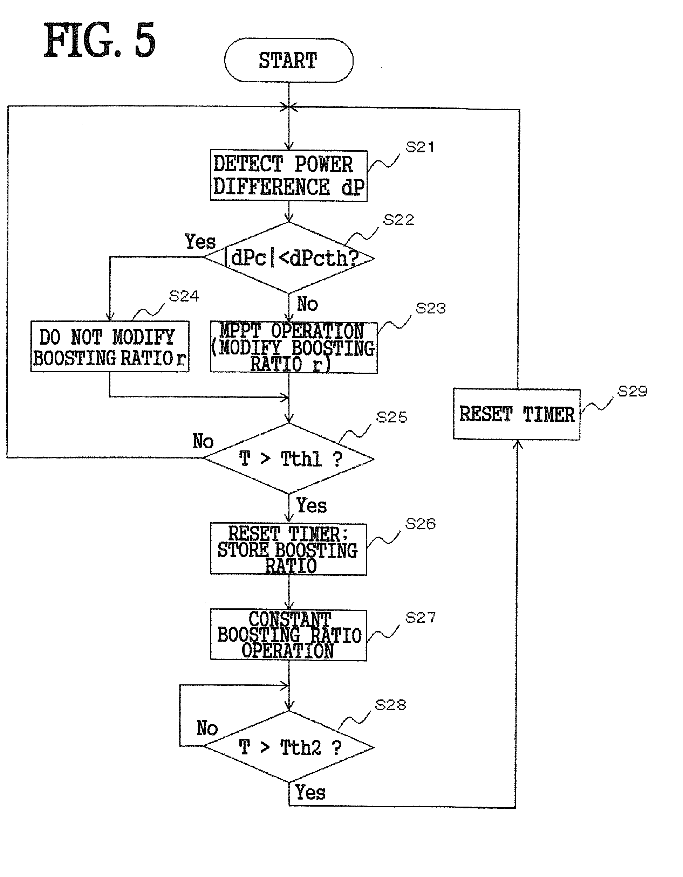

The operation in which the booster 41 repeats the MPPT operation and the constant boosting ratio operation shall now be described with reference to the accompanying drawings. FIG. 5 illustrates a flow chart of the operation for when the MPPT operation and the constant boosting ratio operation of the booster are carried out. The booster 41 begins timing after a counter value T of an addition-type timer is reset to zero (T=0) when this repeat operation is begun, detects and stores an input power Pc to the booster 41 (the reference symbol Pcd is assigned to a stored value of input power), and, in step S21, finds a power difference dPc (= (current power Pc) - (previous power Pcd). This input power Pc (the output power of a solar cell) can be found by detecting the input voltage Vcin and input current Icin of the booster 41 by using the voltage sensor 86 and the current sensor 85, and taking the product of the input voltage Vcin and the input current Icin.

In step S22, a determination is made as to whether or not the absolute value of the power difference dPc is less than dPcth, and when the power difference dPc is less than the threshold value dPcth, the boosting ratio r at the time is fixed (step S24). When the power difference dPc is greater than the threshold value dPcth, the flow proceeds to step S23, in which a new boosting ratio r is set to r = r + dr (the MPPT operation of the booster 41). That is to say, the constant boosting ratio operation is carried out in a case where the output power Pc of a solar cell 1 is near a maximum value ("Yes" for |dPc|<dPcth), and the MPPT operation is carried out in a case where the output power Pc of a solar cell 1 is not near the maximum value ("No" for dPc| <dPcth).

The MPPT operation of the booster 41 comprises modifying the boosting ratio r in the same manner as the previous boosting ratio r has been modified in a case where the power difference dPc is positive (increasing when the boosting ratio r had been increased, and decreasing when the boosting ratio r had been decreased), but modifying the boosting ratio r in a manner different from the manner in which the previous boosting ratio r has been modified in a case where the power difference dPc is negative (decreasing when the boosting ratio r had been increased, and increasing when the boosting ratio r had been decreased). In a case where the process of this step S33 is being carried out for the first time, whether to increase or decrease the boosting ratio r has been decided in advance, and the boosting ratio r is modified accordingly.

Step S25 is a step for controlling the duration of carrying out the MPPT operation, and comprises determining whether or not the counter value T had reached a value Tth1 (set appropriately to match the clock of the counter) corresponding to the duration of the first period B in step S25 (T > Tth1). In the flow chart, the boosting ratio r was fixed when dPc < dPcth in step S24, and the flow proceeds to a second duration C and the boosting ratio r is maintained without alteration when T is determined to be > Tth1.

The boosting ratio r may also be modified by the MPPT operation until the first duration B is timed, without determining that dPc < dPcth in step S22.

When dPc < dPcth is not satisfied upon it being determined that the first duration B has been timed by the timer in step S25, the boosting ratio r of that point in time is used and the second duration C is begun. That is to say, the MPPT operation is temporarily concluded.

The operation in the second duration C (the constant boosting ratio operation), in which the MPPT operation is prohibited, is executed in step S26 to step S28. More specifically, when the second duration C commences, the value t of the counter is first reset, and the boosting ratio r at the time is stored (step S36). Thereafter, the boosting ratio is fixed to the stored boosting ratio r to control the power conversion device 2 (step S37), and the duration for carrying out the constant boosting ratio operation is controlled (step S38). In step S38, a determination is made as to whether or not the count value T has reached a value Tth2 (set appropriately to match the clock of the counter) corresponding to the duration of the second duration (T > Tth2).

When the second duration C has elapsed, the count value of the timer T is reset to zero (stepS39), following which the flow returns again to step S31, the boosting ratio R is changed, and the MPP operation is begun. In this second duration C, the boosting ratio r of when the timing of the first duration B has concluded is fixed and used for control.

The booster 41, in this manner, repeats the steps S21 to S29 and thereby repeats the MPPT operation and constant boosting ratio operation of the booster.

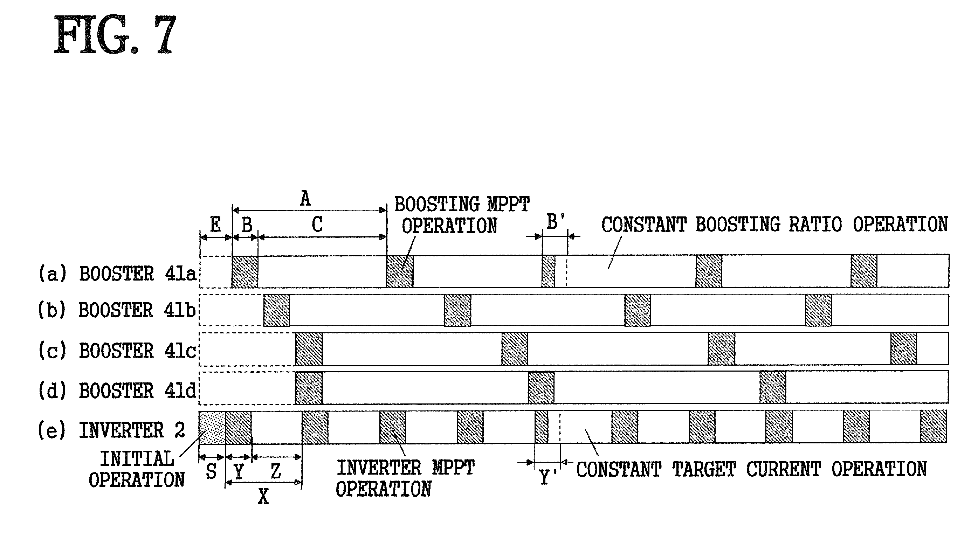

The booster 41 determines whether or not the output power Pc of the solar cell 1 is near the maximum value, decides upon MPPT operation or operation without modifying the boosting ratio (constant boosting ratio), prohibits the MPPT operation after the first duration B has elapsed, and begins the constant boosting ratio operation. For this reason, the booster 41 switches from the MPPT operation to the constant boosting ratio operation (see B' in FIGS. 7, 9, and 12) when the output power of the solar cell 1 becomes close to the maximum value during the MPPT operation in the first duration B.
So doing makes it possible to increase the duration for carrying out the constant boosting ratio operation during the fixed first period A, and therefore makes it possible to reduce the duration for carrying out the MPPT operation of the booster, which has an impact on the MPPT operation of the power conversion device.

### (Operation of the power conversion device)

The power conversion device 2 begins an initial operation, before beginning connection, when the input voltage is greater than a predetermined value (for example, about DC 100 V). When the input voltage becomes greater than a predetermined value (for example, about 100 V) in the initial operation in the power conversion device 2, the booster 21 in the power conversion device 2 begins boosting. When the boosting voltage of the booster 21 tracks a predetermined value (for example, about 300 V), the power conversion device 2 begins to generate an alternating current of a phase synchronized to that of the commercial power grid, using the inverter circuit 23, and begins to close a grid-connecting relay (not shown) to begin connection.

During grid connection, the power conversion device 2 begins the MPPT operation of the power conversion device 2, for operating so that the direct current power obtained by collecting together the power outputted by the solar cells 1a to 1d, at regular intervals of a predetermined second period X. More specifically, one period of the second period X is divided into a third duration Y for enabling the MPPT operation of the power conversion device 2 and a fourth duration Z for prohibiting the MPPT operation of the power conversion device 2. The power conversion device 2 carries out the MPPT operation during the third duration Y, but during the fourth duration Z carries out a constant target current operation for operating so that a target value of the output current of the inverter circuit 23 of the power conversion device 2 is kept constant. In this manner, during grid connection, the power conversion device 2 repeats the MPPT operation and the constant target current operation of the power conversion device 2 at regular intervals of the second period.

The MPPT operation of the power conversion device 2 is carried out as follows, as one example. An input power Ppin (the product of the input current Ipin and the input voltage Vpin) supplied to the booster 21 becomes substantially equal to an output power Ppo superimposed onto the commercial power grid 30 when the conversion efficiency of the power conversion device 2 is understood to be 100% (hereinbelow, the conversion efficiency is treated as being 100%, but a suitable constant may be applied in cases where this conversion efficiency is being considered). The generated power of the solar cells 1 is supplied to the power conversion device 2 by way of the current collection box B, and becomes the input power Ppin, and therefore when the amount of power generated by the solar cells 1 fluctuates, the value of the input power Ppin also changes. The input power Ppi and the output power Ppo are substantially the same, and therefore the input power Ppin can be found from the output current Ipo supplied to the commercial power grid 30 provided that the voltage of the commercial power grid 30 is constant (for example, AC 200 V with a single-phase three-line system). Consequently, the value of the output power Ppo can be matched to the current generated power of the solar cells 1 by changing the value of the output current Ipo.

The inverter circuit 23 controls the switching elements 51 to 54 with a switching signal based on a PWM format obtained by modulating a carrier wave and a sinusoidal modulation wave, to output a single-phase pseudo-sine wave. The amplitude of the pseudo-sine wave is the voltage outputted from the booster 21, and thus the output current Ipo can be controlled by changing the boosting ratio of the booster 21. Consequently, with the maximum value of the generated power of the solar cells at this time, the output current Ipo should be controlled with a target value It, at which the input voltage Ppin tracks a maximum, when the target value It of the output current Ipo is changed.

The booster 21 controls the ON duty of the switching element 82 on the basis of a current difference dIp (= current Ipo - target value It). When the current difference dIp is positive, the value of the ON duty is reduced, and when the current difference dIp is negative, the value of the ON duty is increased. The gain at this time is set as appropriate.

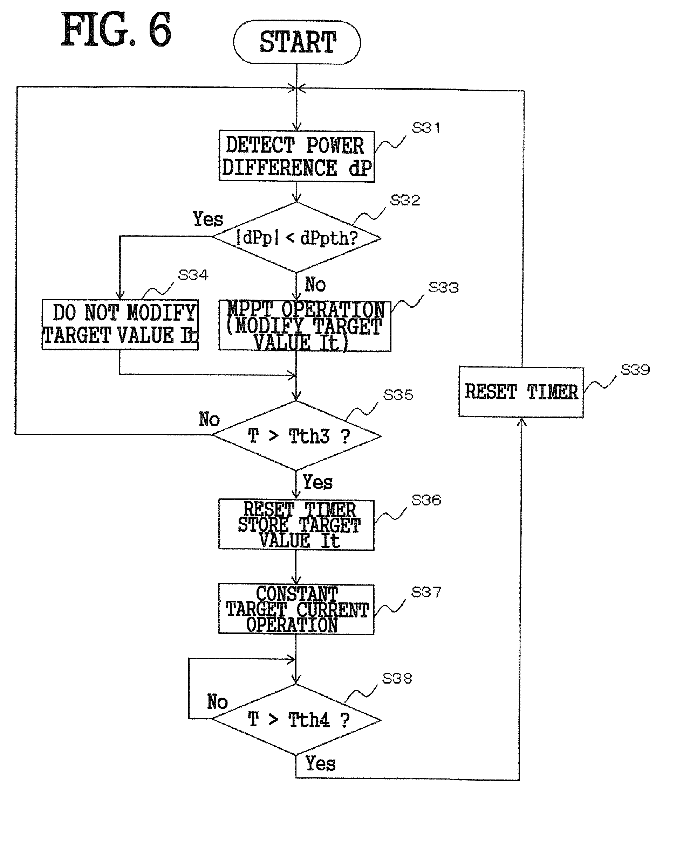

The operation (operation upon grid connection) by which the power conversion device 2 repeats the MPPT operation and the constant target current operation of the power conversion device 2 shall now be described with reference to the drawings. FIG. 6 illustrates a flow chart of the operation of the power conversion device during the grid connection.

The power conversion device 2 begins timing after the counter value T of an addition-type timer is reset to zero (T=0) when the operation during grid connection is begun, detects and stores an input power Ppin to the power conversion device 2, and, in step S31, finds a power difference dPp (= (current power Ppin) - (previous power Ppind).

In step S32, a determination is made as to whether the absolute value of the power difference dPp is less than dPpth and the absolute value of the power difference dPp is less than the threshold value dPpth, then the target value It at the time is fixed (step S34). When the absolute value |dPp| of the power difference is greater than the threshold value dPpth, the flow proceeds to step S33, in which a new target value It for the current is set to be It = It + dI (the MPPT operation of the power conversion device 2). That is to say, the constant target current operation is carried out in a case where the input power Ppin is near the maximum value ("Yes" for |dPp| < dPpth), and the MPPT operation is carried out in a case where the input power Ppin is not near the maximum value ("No" for |dPp| < dPpth).

The MPPT operation of the power conversion device 2 comprises modifying the target value It in the same manner as the previous target value It has been modified in a case where the power difference dPp is positive (increasing when the target value had been increased, and decreasing when the target value had been decreased), but modifying the target value It in a manner different from the manner in which the previous target value It has been modified in a case where the power difference dPp is negative (decreasing when the target value had been increased, and increasing when the target value had been decreased). In a case where the process of step S33 is being carried out for the first time, whether to increase or decrease the target value It has been decided in advance, and the target value It is modified accordingly.

Step S35 is a step for controlling the duration for carrying out the MPPT operation; in step S35, a determination is made as to whether or not the count value T has reached a value Tth3 (set appropriately to match the clock of the counter) equivalent to the duration of the third duration Y (T > Tth3). In the flow chart, the target value It for the current is fixed when dPp < dPpth in step S34; upon determination that T > Tth3, the flow proceeds to a fourth duration Z, and the target value It continues without alteration.

The target value It for the current may also be modified by an MPPT operation until the third duration Y is timed, without determining that dPp < dPpth in step S32.

When dPp < dPpth is not satisfied upon determination that the third duration Y has been timed by the timer in step S35, the target value It of that point in time is used and the fourth duration Z is begun. That is to say, the MPPT operation is temporarily concluded.

The operation of the fourth duration Z (the constant target current operation) for prohibiting the MPPT operation is executed in step S36 to step S38. More specifically, when the fourth duration Z commences, the value t of the time is first reset, and the target value It at the time is stored (step S36). Thereafter, the target value is fixed to the stored target value It and the power conversion device 2 is controlled (step S37), and the duration for carrying out the constant target current operation is controlled (step S38). In step S38, a determination is made as to whether or not the count value T has reached a value Tth4 (set appropriately to match the clock of the counter) equivalent to the duration of the fourth duration Z (T > Tth4).

When the fourth duration Z has elapsed, the count value of the timer T has been reset (step S39), following which the flow returns again to step S31, the target value It of the output current Ipo is changed, and the MPP operation is begun. In this fourth duration Z, the target value It of when the timing of the third duration Y has concluded is fixed and used for control.

When the fourth duration Z is understood to be a duration of zero, the MPPT operation would be continued throughout the X duration of one period, and the target value It would be recalculated at all times.

In the first embodiment, the input power Ppin is found by the product of the input voltage Vpin and the input current Ipin of the booster 21, but it would also be possible to replace with the product of the input voltage and input current of the inverter circuit 23.

The power conversion device 2, in this manner, repeats the steps S31 to S39 and thereby repeats the MPPT operation and constant target current operation of the power conversion device 2.

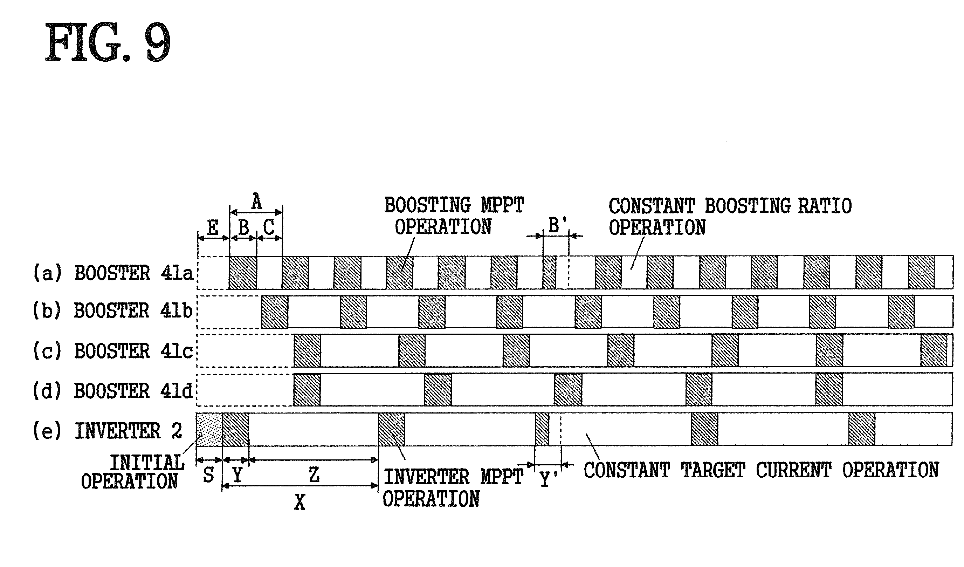

The power conversion device 41 determines whether or not the input power Ppin is near the maximum value, decides upon MPPT operation or operation without modifying the target value of the output current (constant target current, prohibits the MPPT operation after the second period X has elapsed, and begins the constant target current operation. For this reason, the booster 41 switches from the MPPT operation to the constant target current operation (see Y' in FIGS. 7 and 9) when the input power Ppin reaches near the maximum value during the MPPT operation in the third duration Y.

So doing makes it possible to increase the duration for carrying out the constant target current operation during the fixed third period X, and therefore makes it possible to reduce the duration during which there is a conflict between the MPPT operation of the booster and the MPPT operation of the power conversion device.

### (First embodiment)

FIG. 7 illustrates a time chart representing when the current collection box and the power conversion device in the first embodiment are operating. FIGS. 7A to 7D illustrate time charts of when the boosters 41a to 41d, respectively, carry out the MPPT operation, and FIG. 7E illustrates a time chart representing when the power conversion device 2 carries out the MPPT operation.

In FIGS. 7A to 7D, the white duration C corresponds to the second duration C, described above, in which the MPPT operation of the booster 41 is prohibited and the constant boosting ratio operation is carried out, and the diagonally hatched duration B corresponds to the first duration B, described above, in which the MPPT operation of the booster 41 is carried out. The duration A, obtained by adding together the first duration B and the second duration C, is equivalent to the first period A. The duration E, surrounded by the dotted line, corresponds to a duration in which the boosters 41a to 41d do not operate, or alternatively to a duration in which the operation during start-up is being carried out.

In FIG. 7E, the white duration Z corresponds to the fourth duration Z, described above, in which the MPPT operation of the power conversion device 2 is prohibited and the constant target current operation is carried out, and the obliquely hatched duration Y corresponds to the third duration Y, described above, in which the MPPT operation of the power conversion device 2 is carried out. The duration X, obtained by adding up the third duration Y and the fourth duration Z, corresponds to the second period X. The point-hatched duration S corresponds to the duration in which the power conversion device 2 carries out the initial operation. In FIG. 7E, a duration in which the power conversion device 2 does not operate exists before the duration in which the initial operation is carried out, but has been omitted herein.

As will be readily understood by referring to FIG. 7, the first period A is divided into the first duration B for enabling the MPPT operation of the boosters 41 and the second duration C for prohibiting the MPPT operation of the boosters 41, and the second period X is divided into the third duration Y for enabling the MPPT operation of the power conversion device 2 and the fourth duration Z for prohibiting the MPPT operation of the power conversion device 2. The length of the first period A and the length of the second period X are rendered different. For this reason, it is possible to shift the time slots where the MPPT operation of the boosters 41 and the MPPT operation of the power conversion device 2 are carried out, and possible to prevent the MPPT operation of the boosters 41 from interfering with the MPPT operation of the power conversion device 2. The boosters 41 and the power conversion device 2 merely have different control periods, and do not operate by receiving commands from other circuits; accordingly, there is no need to carry out a particular setting for a control circuit for controlling these circuits, making it easy to increase or reduce the lines through the boosters for boosting the output voltage of the solar cells and supplying power.

The length of the second period X is less than the length of the first period A. The output power of the grid-connected system 50 overall is thus more frequently maximized, and the output power of the individual solar cells is maximized more slowly.

The length of the second duration C is rendered greater than the length of the third duration Y. For this reason, one entire MPPT operation of the power conversion device 2 can be carried out during the second duration C in which the MPPT operation of the boosters 41 has no impact. For this reason, the MPPT operation of the boosters 41 can be better prevented from interfering with the MPPT operation of the power conversion device 2.

The length of the fourth duration Z is rendered greater than the length of the first duration B. For this reason, one entire MPPT operation of the boosters can be carried out within the fourth duration. This makes it possible to better prevent the MPPT operation of the boosters from interfering with the MPPT operation of the power conversion device 2.

The period for the boosters in which the MPPT operation of the boosters is begun, and the period of the other boosters in which the MPPT operation of the boosters 41 is begun are different (in the first embodiment, all of the first periods A are set to a different length). Accordingly, for the boosters 41a to 41d, it is possible to shift the timings for carrying out the MPPT operation of each of the boosters 41, as illustrated in FIG. 7. It is also possible to reduce the time slots in which a plurality of the boosters 41 a to 41 d are carrying out the MPPT operation of the power conversion device 2 at the same time. This makes it possible to prevent the MPPT operation of the boosters 41 for the boosters 41 a to 41 d from simultaneously interfering with the MPPT operation of the power conversion device 2.

In a case where the first period A differs for each of the boosters 41a to 41 d, when, among the boosters 41 a to 41 d, the first period is lengthened in correspondence to a solar cell of greater output (for example, the rated output power or the number of series of solar cells), there will be fewer opportunities for the MPPT operation to be carried out on a solar cell that has a greater fluctuation of power when the MPPT operation of the boosters 41 is being carried out. In such a case, there are fewer opportunities for carrying out the MPPT operation of the boosters 41 that dramatically interferes with the MPPT operation of the power conversion device 2, and the MPPT operation of the boosters 41 can be better prevented from interfering with the MPPT operation of the power conversion device 2.

In a case where the first period A differs for each of the boosters 41a to 41d, when, among the boosters 41 a to 41d, the first period is reduced in correspondence to a solar cell of greater output (for example, the rated output power or the number of series of solar cell cells), then there will be more opportunities to carry out the MPPT operation of the boosters 41 on a solar cell from which more power is extracted, making it easier to extract more power from the solar cells 1a to 1d.

The length obtained by adding the lengths of the first duration B within the first period A of each of the boosters 41 a to 41 d is set so as to be less than the length of the second duration C of any of the boosters 41 a to 41 d.

This makes it possible to create a time slot in which the MPPT operation of the boosters 41 is not carried out in any of the boosters 41a to 41d during the first period of the booster 41 having the longest period. For this reason, even though the MPPT operations may suffer interference, one of the MPPT operations is no longer carried out, thus making it possible to avoid this state of interference.

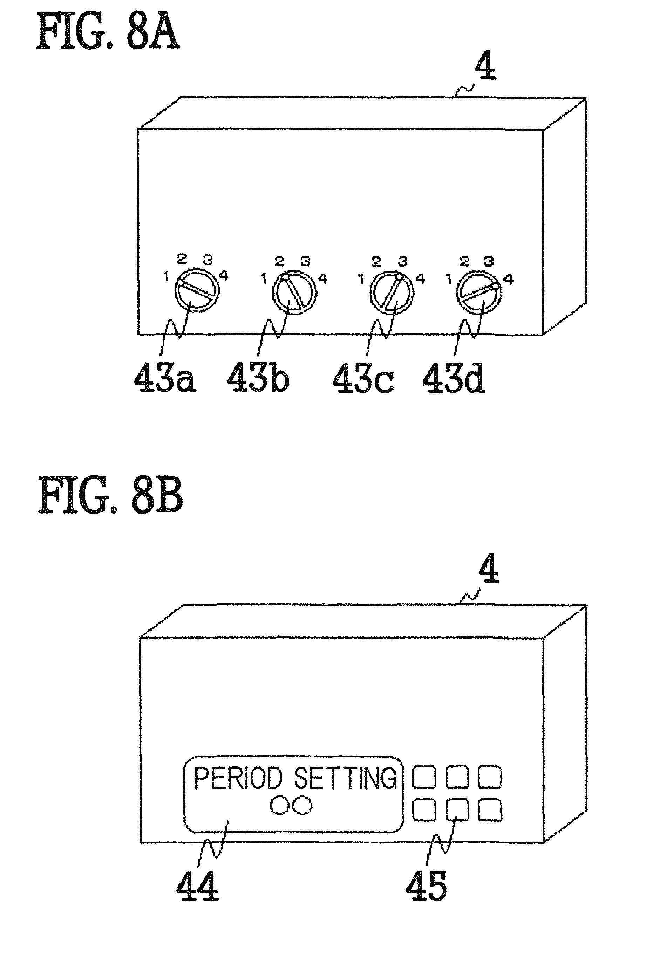

The boosters 41 a to 41 d of the present example have a configuration in which the first period A is modified. FIG. 8 illustrates an external view of the current collection box 4 of the present example. As illustrated in, for example, FIG. 8A, a number of rotary switches 43a to 43d commensurate with the boosters 41 may be provided, each of the rotary switches 43a to 43d being respectively used to modify the first period A of the boosters 41 a to 41d. In such a case, the boosters 41a to 41d are respectively allocated to the rotary switches 43a to 43d, and the length of the first period A can be set in accordance with the position of rotation of the rotary switches 43a to 43d. Also, as illustrated in, for example, FIG. 8B, operating a button 45 while also viewing a display unit 44 may enable modification of the first period A of the boosters 41 a to 4 1 d.

### (Second embodiment)

The first embodiment described a case where the second period X is shorter than the first period A, but in the second embodiment, the second period X is longer than the first period A. The configuration used can be otherwise similar with respect to the configuration described thus far, and therefore a description thereof has been omitted.

FIG. 9 illustrates a time chart representing when a current collection box and a power conversion device in a second embodiment are operating. FIGS. 9A to 9D illustrate time charts representing when the boosters 41a to 41 d, respectively, are carrying out the MPPT operation, and FIG. 9E illustrates a time chart representing when the power conversion device 2 is carrying out the MPPT operation.

In FIGS. 9A to 9D, the representation of each of the periods and durations A to C, E, S, and Y to Z is the same as in FIG. 7, and therefore a description thereof has been omitted.

As illustrated in FIG. 9, the length of the second period X is greater than the length of the first period A. This causes the output power of the grid-connected system 50 overall to be more slowly maximized, and causes the output power of the individual solar cells to be more frequently maximized.

The fourth duration is also longer than the first period A of each of the boosters. This provides a duration in which, during the fourth duration of the power conversion device 2, all of the boosters carry out at least one MPPT operation. This causes the MPPT operation of the power conversion device 2 to be carried out with the output power of the individual solar cells having been maximized in all of the boosters 41a to 41 d, and therefore the output power of the grid-connected system 50 overall is more readily maximized.

Embodiments of the present invention have been described above, but the foregoing description serves to facilitate understanding of the present invention, and not to limit the present invention. It shall be readily understood that the present invention can also be modified or improved without departing from the spirit thereof, and that the present invention encompasses equivalents thereof.

### (Modification 1)

For example, in the present embodiment, the boosters 41 prohibited the MPPT operation and began the constant boosting ratio operation when the fixed first duration B had elapsed, but the MPPT operation may be prohibited and the constant boosting ratio operation carried out in a case where the output power Pc of the solar cells 1 is determined to be near the maximum value. This configuration allows for the length of the first duration B to be modified in accordance with the output power Pc of the solar cells 1, and the length of the second duration C would then be fixed to a constant length.

More specifically, the flow would transition to the second duration B when the output power Pc of the solar cells 1 reaches near the maximum value, and therefore the first duration B would be shorter and the first period A would also be shorter (the length of the first period A changes). When the length of the first period A changes, the timing at which the MPPT control of the boosters is begun is shifted. For this reason, it is possible to shift the durations in which the MPPT operation of the boosters and the MPPT operation of the power conversion device 2 are carried out simultaneously, and therefore possible to minimize the impact of the MPPT operation of the boosters 41 on the MPPT operation of the power conversion device 2.

### (Modification 2)

Also, for example, in the present embodiment the power conversion device 2 prohibited the MPPT operation and began the constant target current operation after the fixed third duration Y had elapsed, but the MPPT operation may be prohibited and the constant target current operation carried out in a case where the input power Ppin is determined to be near the maximum value. This configuration allows for the length of the third duration Y to be modified in accordance with the input power Ppin, and the length of the fourth duration Z would then be fixed to a constant length.

More specifically, the flow would transition to the fourth duration Z when the input power Ppin reaches near the maximum value, and therefore the third duration Y would be shorter and the second period X would also be shorter (the length of the second period X changes). When the length of the second period X changes, the timing at which the MPPT control of the power conversion device 2 is begun is shifted. For this reason, it is possible to shift the durations in which the MPPT operation of the boosters and the MPPT operation of the power conversion device 2 are carried out simultaneously, and therefore possible to minimize the impact of the MPPT operation of the boosters 41 on the MPPT operation of the power conversion device 2.

### (Modification 3)

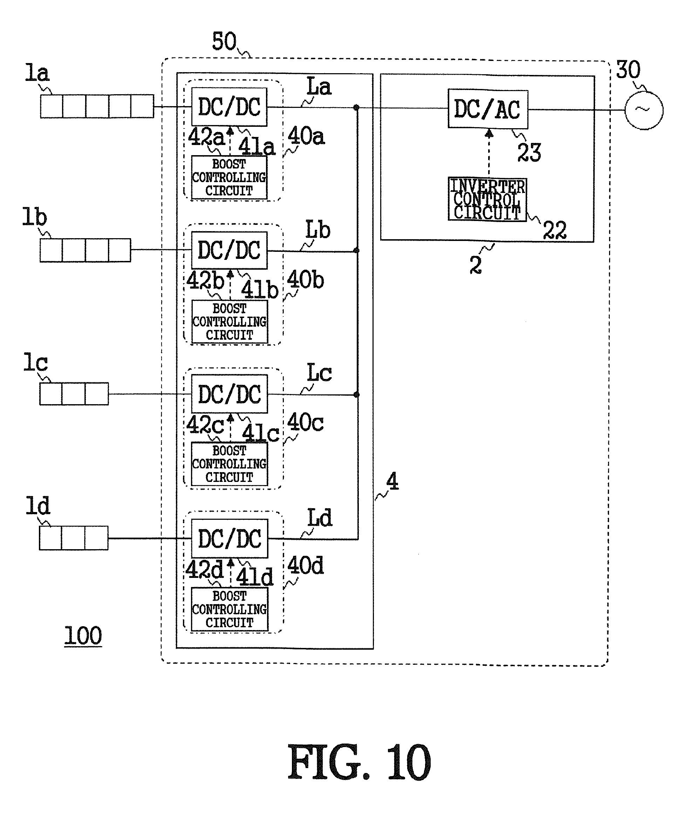

Also, for example, in the present embodiment the booster 21 was provided to the power conversion device 2 as well, but it would also be possible to employ a configuration in which the booster 21 is not provided to the power conversion device 2, as illustrated in FIG. 10.

### (Modification 4)

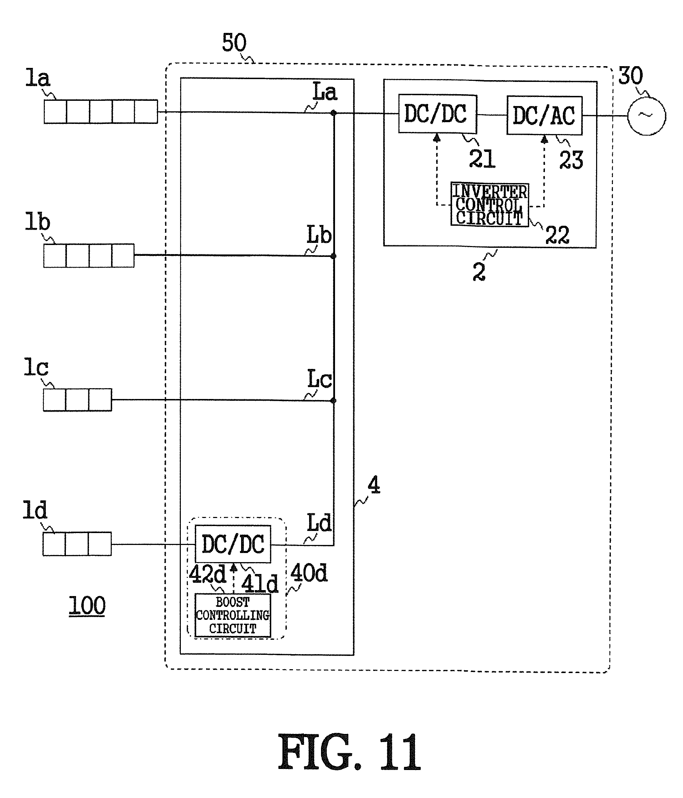

Also, for example, in the present embodiment a configuration to which the boosters 41a to 41d (boosting units 40a to 40d) are connected was used for all of the solar cells 1a to 1d, but any one of the solar cells 1 may also not have a booster 41 (boosting unit 40) connected, the solar cell 1a being connected directly to the output side of another booster 41, as illustrated in FIG. 11.

### (Modification 5)

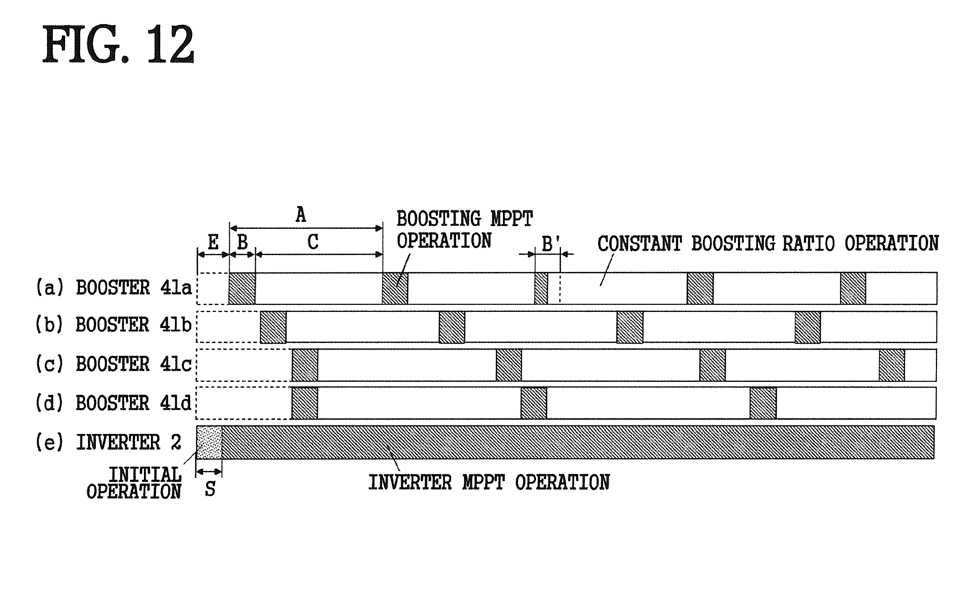

Also, for example, in the present embodiment the third duration for carrying out the MPPT operation of the power conversion device 2 and the fourth duration for prohibiting the MPPT operation of the power conversion device 2 were provided and a constant second period X was set, but the fourth duration may be set to zero (see FIG. 12). In such a case, the MPPT operation of the power conversion device 2 would be carried out substantially at all times. Because a duration for prohibiting the MPPT operation of the boosters 41 is provided to the first period A, thus forming a duration in which the MPPT operation of the power conversion device 2 and the MPPT operation of the boosters 41 of the current collection box 4 are not carried out simultaneously, any interference conceivably produced between the two MPPT operations would then be eliminated during this duration. Consequently, the MPPT operation of the power conversion device 2 is repeatedly carried out at a timing of a program incorporated into the main routine of a microcomputer program within the power conversion device 2, and an operation of comparison of maximum power is carried out and the boosting ratio is updated at regular intervals of this repetition period.

### (Modification 6)

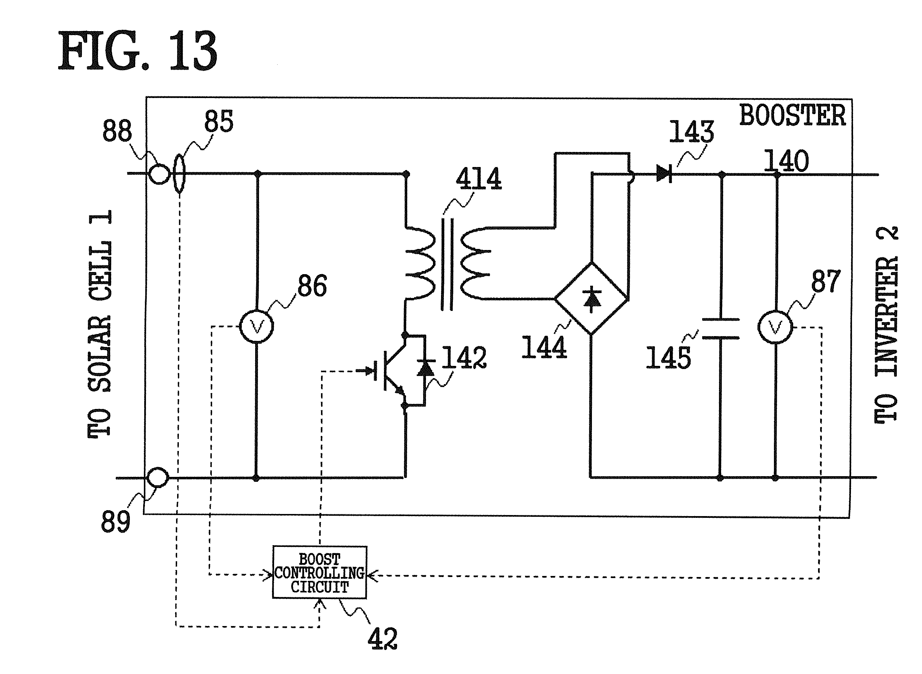

Also, for example, in the present embodiment a non-isolated booster was used for the boosters 41 of the current collection box 4, but it would also be possible to use an isolated booster 140, in which a transformer 141 is used, as illustrated in FIG. 13. The booster 140 has on a primary side a circuit in which a primary-side winding of the transformer 141 and a switch element 142 are connected together in series. The booster 140 also has a rectifier 144 on a secondary side, and has a circuit in which a secondary-side winding of the transformer 141 being connected to an alternating current side of the rectifier 144, a diode 143 being connected in series with a direct current side of the rectifier 144, and a capacitor 145 being connected in parallel with the rectifier 144 and a series circuit of the diode 143.

The booster 140 also has the current sensor 85 for detecting the input current, the voltage sensor 86 for detecting the input voltage, and the voltage sensor 87 for detecting the output voltage; the switch element 142 is periodically opened or closed to obtain a predetermined boosting ratio on the basis of information obtained from these sensors.

In a case where the isolated booster 140 of such description is utilized, the output power of the solar cells 1 is not supplied to the power conversion device 2 when the switch element 142 is opened, and therefore start-up from the current collection box 4 is necessary. In a case where such an operation is carried out, the operation of the isolated booster 140 can be handled by adding a step for operating with a constant boosting ratio before step S11 of FIG. 4.
The booster 140 illustrated in FIG. 13 is one example of an isolated booster; the same may also apply to other isolated boosters.

### [Key to Symbols]

- 1a to 1d:: Solar cell
- 2:: Power conversion device
- 4:: Current collection box
- 21:: Booster
- 22:: Inverter control circuit
- 23:: Inverter circuit
- 30:: Commercial power grid
- 40a to 40d:: Boosting unit
- 41a to 41d:: Booster
- 42a to 42d:: Boost controlling circuit
- 43a to 43d:: Rotating switch
- 44:: Display unit
- 45:: Button
- 50:: Grid-connected system

## Claims

1. A current collection box provided with a number of terminals enabling the connecting of at least two solar cell strings including a plurality of solar cells are connected in series, the generated power from the solar cell strings inputted via the terminals being controlled so as to track a maximum value and thereafter being outputted, wherein the current collection box is **characterized by** being provided with:
a booster for boosting individual voltages of the generated power of each of the solar cell strings inputted via the terminals, and an output circuit for collecting all of the outputs of the boosters together into a single output and then outputting the single output, each of the boosters controlling a boosting ratio to yield a maximum value of generated power corresponding to a voltage applied over a certain duration in respective every predetermined periods, and the periods during which each of the boosters is actuated being set to a different value.

2. The current collection box as set forth in claim 1, **characterized in that** when a certain duration of the period is a first duration and a remaining duration is a second duration in which the boosting ratio is fixed to a certain value, a time length obtained by taking the sum of the length of the first duration of each of the boosters is shorter than any of the second durations.

3. The current collection box as set forth in claim 1 or claim 2, **characterized in that** the boosters are capable of modifying the period.

4. The current collection box as set forth in any of claims 1 to 3, **characterized in that** the length of the first duration is modifiable and the length of the second duration is fixed to a predetermined length, and the boosters, while the boosting ratio in the first duration is controlled, stop control of the boosting ratio in the first duration and fix the boosting ratio when a variation in the generated power of the solar cells falls below a predetermined amount, and thereafter in the second duration the operation of the boosters is carried out at the fixing boosting ratio.

5. The current collection box as set forth in any of claims 1 to 4, **characterized in that** the boosters have a current detection circuit for detecting a current inputted to or outputted by the boosters, and in a case where the current detected by the current detection circuits is greater than a predetermined value during start-up, the boosters control the boosting ratio.
